# EUROPEAN PATENT APPLICATION

(11) **EP 2 770 530 A2**
(43) Date of publication of application: **27.08.2014**
(21) Application number: 14153718.3
(22) Date of filing: 03.02.2014
(51) Int. Cl.: H01L 23/36, H01L 23/367, H01L 23/40

(54) **Electronic component unit and fixing structure**

(30) Priority: 22.02.2013 JP 2013032788
(71) Applicant: FUJITSU LIMITED, Kawasaki-shi, Kanagawa 211-8588 (JP)
(72) Inventor: Kobayashi, Yoko, Kawasaki-shi, Kanagawa 211-8588 (JP); So, Tsuyoshi, Kawasaki-shi, Kanagawa 211-8588 (JP); Itoh, Nobutaka, Kawasaki-shi, Kanagawa 211-8588 (JP); Ochi, Yoshiteru, Kawasaki-shi, Kanagawa 211-8588 (JP); Nakata, Katsuhiko, Kawasaki-shi, Kanagawa 211-8588 (JP)
(74) Representative: Fenlon, Christine Lesley

(57) **Abstract**

An electronic component unit includes a semiconductor package mounted on a front surface of a substrate, a heat sink including a pushing plate installed on the semiconductor package, a reinforcing plate disposed on a back surface of the substrate, and a plurality of fasteners that connect corner portions of the pushing plate and the reinforcing plate to each other, wherein the semiconductor package is pressed and fixed on the substrate by fastening the plurality of fasteners, and the reinforcing plate includes a base plate portion including a connection portion to which each of the plurality of fasteners is connected, and a pressing plate portion which is disposed at a planar central side of the base plate portion, and separably laminated on the base plate portion to press the back surface of the substrate.

## Description

The embodiments relate to an electronic component unit and a fixing structure.

An electronic component unit is generally installed in an electronic device such as a server computer device. The electronic component unit is equipped with a semiconductor package such as a large scale integrated circuit (LSI) chip package that is mounted on a system board. As the processing capability and the speed of the central processing unit (CPU) have been improved, there is a tendency that a heat generation amount of a semiconductor chip is increased. Therefore, a heat radiator called a heat sink is mounted in the semiconductor package so as to cool the semiconductor chip of the semiconductor package. See, for example, Japanese Laid-open Patent Publication No. 2003-78298 and Japanese Patent No. 4744290.

The heat sink is generally accommodated on the semiconductor package by, for example, interposing a thermal conductive sheet, which is called a thermal sheet, between the heat sink and the semiconductor package. The heat generated from the semiconductor chip may be efficiently transferred to the heat sink by bringing the thermal sheet into close contact with both the heat sink and the semiconductor package.

The heat sink is connected to the system board by, for example, a bolt in order to be fixed. In addition, in order to improve the cooling effect of the semiconductor chip, it is necessary to increase the degree of adhesion of the thermal sheet to the heat sink and the semiconductor package. Therefore, a bolster plate, which is a reinforcing plate, is disposed at a back surface side of the system board, and the front end of the bolt, which penetrates a base plate of the heat sink and the system board, is connected to a connection portion formed at a corner portion of the bolster plate. Further, the degree of adhesion of the thermal sheet to the semiconductor package and the heat sink is increased by interposing the system board and the semiconductor package mounted on the system board between the bolster plate and the base plate, and fastening the bolt.

However, the bolster plate of the related art includes a structure with only one sheet of a thick plate, and therefore, bending or deflection of the bolster plate easily occurs when the bolt connected to the connection portion of the bolster plate is fastened. Then, it is difficult to uniformly press the system board using the bolster plate. As a result, there is a concern in that the system board may be bent, and thus a large amount of stress may be applied to an electrode portion of the semiconductor package causing damages to the electrode portion. In addition, there is a concern in that the degree of adhesion of the thermal sheet interposed between the semiconductor package and the heat sink deteriorates, and thus a cooling efficiency of the semiconductor package (e.g., semiconductor chip) may deteriorate.

Accordingly, it is an aim of the invention to provide an electronic component unit and a fixing structure capable of, for example, suppressing deterioration in cooling efficiency of a semiconductor package and damage to an electrode portion.

An aspect of the invention provides an electronic component unit includes a semiconductor package mounted on a front surface of a substrate, a heat sink including a pushing plate installed on the semiconductor package, a reinforcing plate disposed on a back surface of the substrate, and a plurality of fasteners that connect corner portions of the pushing plate and the reinforcing plate to each other, wherein the semiconductor package is pressed and fixed on the substrate by fastening the plurality of fasteners, and the reinforcing plate includes a base plate portion including a connection portion to which each of the plurality of fasteners is connected, and a pressing plate portion which is disposed at a planar central side of the base plate portion, and separably laminated on the base plate portion to press the back surface of the substrate.

The aims and advantages of the disclosure will be realized and attained by means of the elements and combinations particularly pointed out in the claims. It is to be understood that both the foregoing general description and the following detailed description are exemplary and explanatory, and are not restrictive of the disclosure as claimed.

According to the present application, an electronic component unit and a fixing structure capable of suppressing deterioration in cooling efficiency of a semiconductor package, and damages to an electrode portion, may be provided. The scope of the invention is defined by the claims. The invention is described below, by way of example only, with reference to the figures, in which:
FIG. 1 is a view schematically illustrating a cross-sectional structure of an electronic component unit according to Embodiment 1;
FIG. 2 is an exploded perspective view of a bolster plate according to Embodiment 1;
FIG. 3 is a perspective view of the bolster plate according to Embodiment 1;
FIG. 4 is a plan view of the bolster plate according to Embodiment 1;
FIG. 5 is a plan view of a base plate portion according to Embodiment 1;
FIG. 6 is a view illustrating a state where the bolster plate according to Embodiment 1 is mounted on a system board;
FIG. 7A is a view explaining a bolster plate of the related art (1);
FIG. 7B is a view explaining a bolster plate of the related art (2);
FIG. 8 is a view explaining behavior of the bolster plate according to Embodiment 1;
FIG. 9A is a view illustrating a modified example of the bolster plate according to Embodiment 1 (1);
FIG. 9B is a cross-sectional view taken along an arrow line A-A of FIG. 9A;
FIG. 10 is a view illustrating a modified example of the bolster plate according to Embodiment 1 (2);
FIG. 11 is a view schematically illustrating a cross-sectional structure of an electronic component unit according to Embodiment 2; and
FIG. 12 is a view schematically illustrating a cross-sectional structure of an electronic component unit according to a modified example of Embodiment 2.

The embodiments have been made in consideration of the aforementioned problems described in the related art, and an aim of the present disclosure is to provide an electronic component unit and a fixing structure capable of, for example, suppressing deterioration in cooling efficiency of a semiconductor package, and damage to an electrode portion.

Hereinafter, embodiments according to an electronic component unit and a fixing structure will be described in detail with reference to the drawings.

### <Embodiment 1>

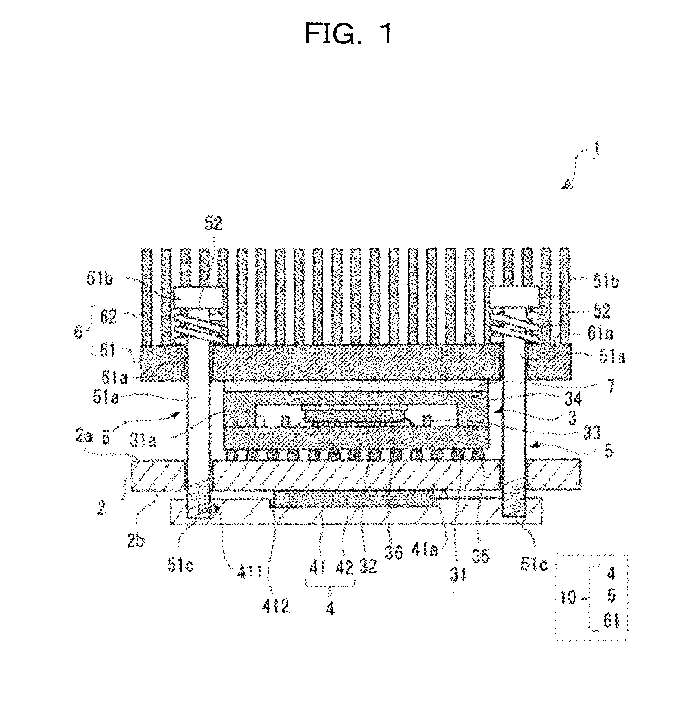

FIG. 1 schematically illustrates a cross-sectional structure of an electronic component unit 1 according to Embodiment 1. The electronic component unit 1 includes, for example, a system board 2, a semiconductor package 3, a bolster plate 4, fasteners 5, and a heat sink 6. As for the system board 2, a resin substrate is used as an example. An upper surface *(e.g.,* a front surface) 2a of the system board 2 serves as a mounting surface of the semiconductor package 3, and the semiconductor package 3 is mounted thereon. The system board 2 is an example of a substrate. The electronic component unit 1 is accommodated in a case of an electronic device such as, for example, a server computer device.

The semiconductor package 3 includes, for example, a package substrate 31, a semiconductor chip 32, a chip component 33, and a heat spreader 34. For example, a connection structure between the semiconductor package 3 and the system board 2 adopts a ball grid array (BGA) mounting method. The package substrate 31 has an approximately rectangular outline, and is formed, for example, by a glass epoxy multilayered substrate. A plurality of solder bumps 35, that is, the BGA is disposed on a lower surface (*e.g.,* a back surface) of the package substrate 31. The semiconductor package 3 is electrically bonded on the upper surface 2a of the system board 2 by the solder bumps 35.

In addition to the semiconductor chip 32, the chip component 33 such as, for example, a chip capacitor or a chip resistor is mounted on an upper surface 31a of the package substrate 31. Meanwhile, the semiconductor chip 32 or the chip component 33 is electrically connected to a terminal of the package substrate 31 by, for example, a flip chip connection method.

The heat spreader 34 of the semiconductor package 3 is a member that serves as a lid (*e.g.,* a cap) which seals the semiconductor chip 32 and may transfer the heat of the semiconductor chip 32, which is a heat-generating element, to the heat sink 6. The heat spreader 34 is adhered (bonded) on the upper surface 31a of the package substrate 31 by, for example, a thermosetting resin. The heat spreader 34 may be made of a metallic material such as, for example, copper or aluminum having an excellent thermal conductivity *(e.g.,* a heat transfer property).

The heat spreader 34 and the semiconductor chip 32 are thermally bonded by a metallic bonding material 36 having, for example, a low thermal resistance. Accordingly, the property of transferring heat from the semiconductor chip 32 to the heat spreader 34 may be improved. Meanwhile, a thermal sheet (*e.g.,* a thermal conductive sheet) may be adopted instead of the metallic bonding material 36.

The heat sink 6 is accommodated on the semiconductor package 3. The heat sink 6 includes a pushing plate 61 that becomes wider along a plane direction of the system board 2. The pushing plate 61 is a flat plate member having an outline that becomes wider outwardly than the semiconductor package 3. The pushing plate 61 is seated on an upper portion of the heat spreader 34. A thermal sheet (*e.g.,* a thermal conductive sheet) 7 is interposed between the heat spreader 34 and the pushing plate 61 and comes into close contact with the heat spreader 34 and the pushing plate 61, such that the heat spreader 34 and the pushing plate 61 are in thermal contact with each other.

The heat sink 6 also includes a plurality of sheets of heat radiating fins 62 that is adhered or firmly fixed to the pushing plate 61. The plurality of heat radiating fins 62 is a thin plate-shaped heat radiating plate. Each of the heat radiating fins 62 is installed erectly to rise in a vertical direction from the upper surface of the pushing plate 61. In addition, the respective heat radiating fins 62 are arranged to be parallel to each other, and ventilation passages, which are extended in the same direction, are formed to be partitioned between the adjacent heat radiating fins 62. The pushing plate 61 and the heat radiating fins 62 may be made of a metallic material such as, for example, aluminum or copper.

The heat sink 6 is connected to the system board 2 by a fixing structure 10 including, for example, the bolster plate 4, and the fasteners 5, in a state where the semiconductor package 3 is interposed between the heat sink 6 and the system board 2. Further, the heat generated from the semiconductor chip 32 is transferred to the heat sink 6 through the metallic bonding material 36, the heat spreader 34 and the thermal sheet 7. Further, the heat transferred to the pushing plate 61 of the heat sink 6 is transferred from the pushing plate 61 to the plurality of heat radiating fins 62, and then dissipated to the atmosphere through the plurality of heat radiating fins 62.

The fixing structure 10 provided in the electronic component unit 1 will be described next. The fixing structure 10 includes one set of pushing plates which is disposed to be opposite to each other, and a plurality of fasteners 5 which connects corner portions of the one set of pushing plates to each other, and fixes a plurality of objects to be fixed by fastening the fasteners 5 in a state where the plurality of objects to be fixed is interposed between the one set of pushing plates. In the present embodiment, an example in which one of the one set of pushing plates serves as the pushing plate 61 of the heat sink 6, and the other servers as the bolster plate 4, will be described. In addition, in the present embodiment, the system board 2 and the semiconductor package 3 mounted on the system board 2 are included in the plurality of objects to be fixed. The electronic component unit 1 fixes the system board 2 and the semiconductor package 3 by fastening the fasteners 5 of the fixing structure 10, pressing the semiconductor package 3 against the system board 2, and increasing a degree of fixation of the semiconductor package 3 against the system board 2.

The fasteners 5 are disposed at four corners of the pushing plate 61 of the heat sink 6. The fasteners 5 fix the heat sink 6 to the system board 2 by pressing the pushing plate 61 of the heat sink 6 against an upper surface *(e.g.,* the heat spreader 34) of the semiconductor package 3. As illustrated in FIG. 1, the fastener 5 includes a bolt 51 and a spring 52. The fastener 5 is disposed in a region positioned further outwardly than a region in which the semiconductor package 3 is disposed.

The bolt 51 includes a shaft portion 51a, and a head portion 51b that is formed at a proximal end side of the shaft portion 51a. In addition, a threaded portion 51c is formed at a front end side of the shaft portion 51a. Meanwhile, through holes 61a into which the shaft portions 51a of the bolts 51 are penetratively inserted are perforated at the four corners of the pushing plate 61 of the heat sink 6. A diameter of the through hole 61a is larger than a diameter of the shaft portion 51a, and smaller than a diameter of the head portion 51b. The bolt 51 passes through the through hole 61a of the pushing plate 61 in a state where the spring 52 is interposed between the head portion 51b and the pushing plate 61. The bolt 51 is disposed on an extension line of a diagonal line of a bottom surface of the semiconductor package 3. However, a plane position at which the bolt 51 is disposed may be properly changed.

The bolt 51 passes through the system board 2, and is connected to the bolster plate 4 that is disposed at a lower surface (back surface) 2b side of the system board 2. In detail, a through hole is formed in the system board 2 in order to penetratively insert the shaft portion 51a of the bolt 51 such that the shaft portion 51a is penetratively inserted into the through hole. Meanwhile, the bolster plate 4 is a plate-shaped member that is disposed along the lower surface (back surface) 2b of the system board 2. The bolster plate 4 is connected to the pushing plate 61 of the heat sink 6 through the fastener 5 (bolt 51). The bolster plate 4 serves as a reinforcing plate for suppressing deformation such as bending and deflection of the system board 2 by uniformly pressing the lower surface *(e.g.,* the back surface) 2b of the system board 2 when the fasteners 5 are fastened.

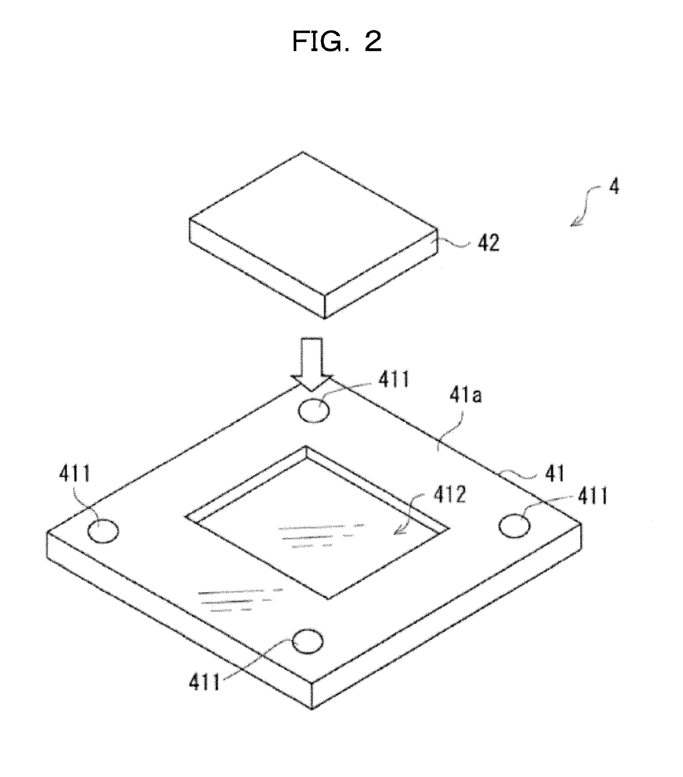

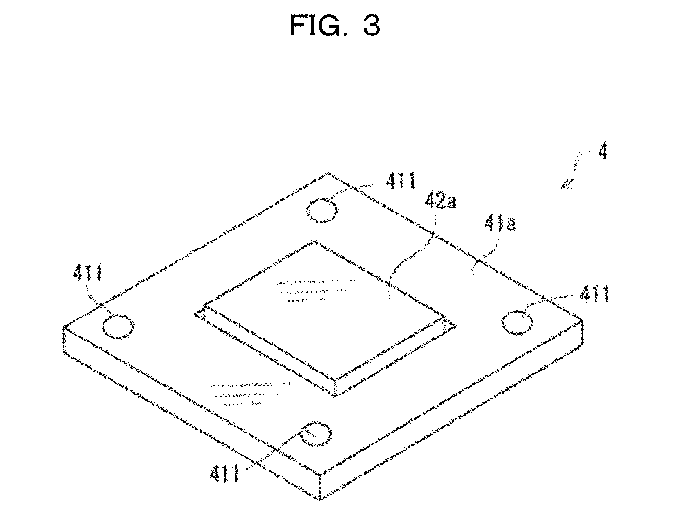

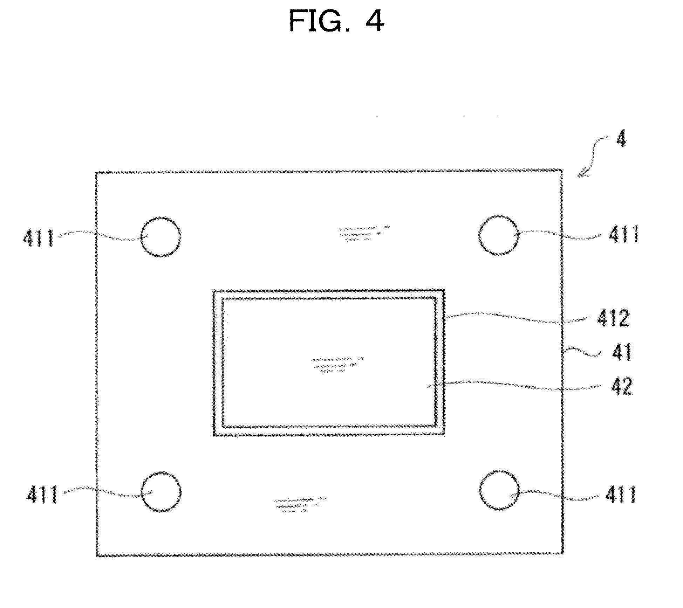

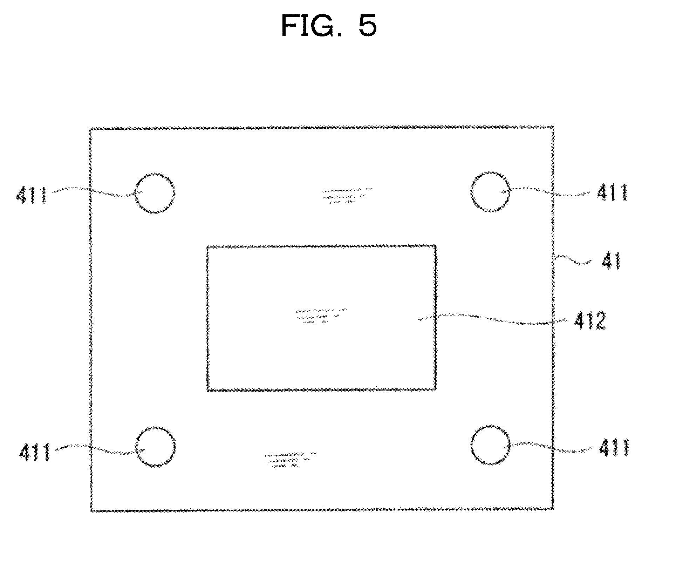

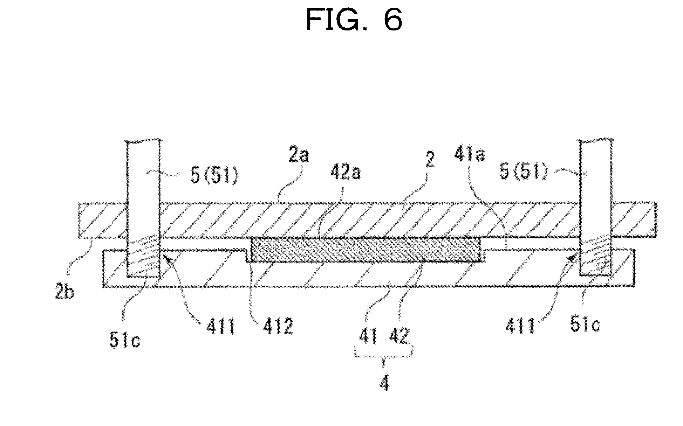

FIG. 2 is an exploded perspective view of the bolster plate 4. FIG. 3 is a perspective view of the bolster plate 4. FIG. 4 is a plan view of the bolster plate 4. FIG. 5 is a plan view of a base plate portion 41 of the bolster plate 4. FIG. 6 is a view illustrating a state where the bolster plate 4 is mounted on the lower surface 2b of the system board 2. Meanwhile, the illustrations of the semiconductor package 3 and the heat sink 6 which are mounted on the system board 2 are omitted in FIG. 6.

The bolster plate 4 according to the present embodiment includes the base plate portion 41, and a pressing plate portion 42 that is separably laminated and disposed on the base plate portion 41. In the bolster plate 4, the base plate portion 41 and the pressing plate portion 42 are flat plate members having a rectangular flat surface, as illustrated in FIGS. 3 to 5. However, the shapes of the flat surface of the base plate portion 41 and the pressing plate portion 42 are not limited to the rectangular shape, but various shapes such as a circular shape, an elliptical shape and a polygonal shape may be adopted. In addition, for example, stainless steel may be exemplified as a material used for the base plate portion 41 of the bolster plate 4. In addition, for example, stainless steel, an aluminum alloy, or a copper alloy may be exemplified as a material of the pressing plate portion 42.

Connection portions 411 to which each of the fasteners 5 is connected are formed at the corner portions of the base plate portion 41, more particularly, the four corners in a plane direction of the base plate portion 41. The connection portion 411 includes an insertion hole that is a hole into which the front end side of the bolt 51 is inserted, and an internal thread for screw-coupling the threaded portion 51c is formed on an inner wall surface of the insertion hole. The bolt 51 passing through the pushing plate 61 of the heat sink 6 and the through hole of the system board 2 is connected to the base plate portion 41 by screw-attaching the threaded portion 51c to the connection portion 411 installed at the corner portion of the base plate portion 41 of the bolster plate 4.

In the base plate portion 41, a surface of a side disposed to be opposite to the lower surface 2b of the system board 2 is called "an inner surface 41a". A concave portion 412 is formed in the inner surface 41a of the base plate portion 41. The concave portion 412 is formed at a planar central side of the inner surface 41a. Further, the pressing plate portion 42 of the bolster plate 4 is fitted into the concave portion 412 of the base plate portion 41. Here, the planar central side refers to at least a region of the inner surface 41a of the base plate portion 41, which is positioned further inwardly than each of the connection portions 411. In the present embodiment, because the connection portions 411 are formed at the four corners of the inner surface 41a, and the concave portion 412 is formed in at least a portion of a region enclosed by the connection portions 411 such that the pressing plate portion 42 is disposed. In addition, in the base plate portion 41, a thickness of a portion where the concave portion 412 is formed is smaller than that of the other portion.

The planar shapes of the concave portion 412 and the pressing plate portion 42 resemble each other, and the concave portion 412 is formed to be slightly larger in a horizontal projection area than the pressing plate portion 42. As a result, as illustrated in, for example, FIGS. 3, 4, 6, a gap having a predetermined dimension is formed between a lateral surface of the pressing plate portion 42 and a lateral surface of the concave portion 412 in a state where the pressing plate portion 42 is fitted into the concave portion 412. As described above, the pressing plate portion 42 is fitted into the concave portion 412 while forming a clearance between the lateral surface of the pressing plate portion 42 and the lateral surface of the concave portion 412 of the base plate portion 41. That is, the pressing plate portion 42 is movably fitted into the concave portion 412 of the base plate portion 41 so as to be separably laminated on the base plate portion 41.

The depth of the concave portion 412 of the base plate portion 41 and a thickness (plate thickness) of the pressing plate portion 42 will be described. In the present embodiment, a thickness dimension of the pressing plate portion 42 is defined as a dimension larger than a depth dimension of the concave portion 412. As a result, when the pressing plate portion 42 is fitted into the concave portion 412 of the base plate portion 41, a part *(e.g.,* an upper portion side) of the pressing plate portion 42 protrudes from an upper portion of the concave portion 412, while the entire pressing plate portion 42 is not inserted into the concave portion 412. That is, in a state where the base plate portion 41 is fitted into the concave portion 412, the upper surface 42a of the pressing plate portion 42 is disposed at a position higher than the periphery of the concave portion 412.

The operation of the bolster plate 4, which is implemented by the fixing structure 10 according to the present embodiment, when the respective fasteners 5 (bolt 51) are fastened, will be described next. When the fasteners 5 are fastened, the spring 52 applies elastic force in an extension direction between the head portion 51b and the pushing plate 61. That is, by the elastic force of the spring 52 in the extension direction, pressing force is applied from the spring 52 to the pushing plate 61 and the bolster plate 4 in a direction in which an interval between the pushing plate 61 of the heat sink 6 and the bolster plate 4, which are disposed to be opposite to each other, becomes small. As a result, the pushing plate 61 of the heat sink 6 is pressed by a predetermined amount of pressing force toward the semiconductor package 3 (particularly, the heat spreader 34), thereby increasing the degree of fixation between the heat sink 6, the semiconductor package 3 and the system board 2. In addition, the thermal sheet 7 interposed between the pushing plate 61 and the heat spreader 34 is uniformly pressed and crushed such that the thermal sheet 7 comes into close contact with both the pushing plate 61 and the heat spreader 34, thereby improving the cooling efficiency of the semiconductor chip 32.

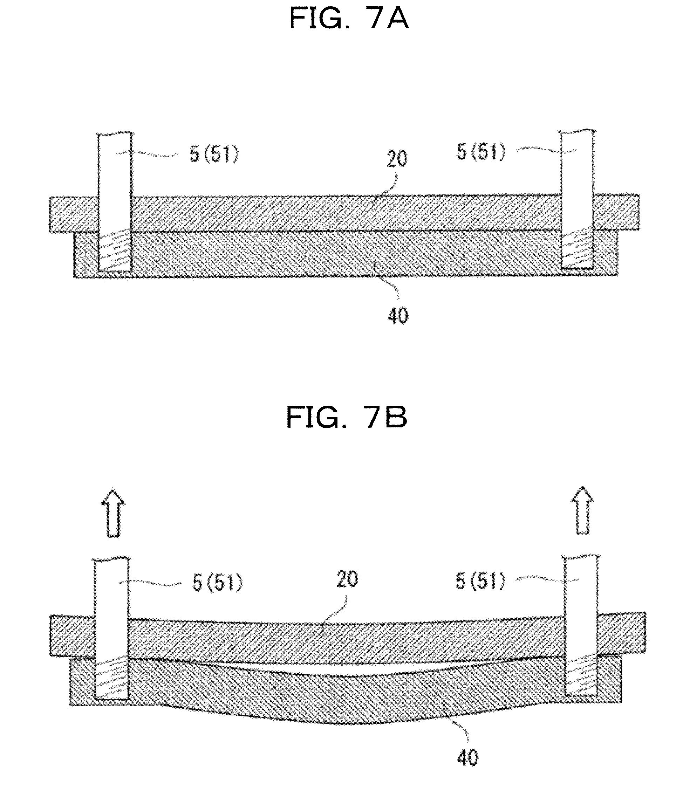

However, when the respective fasteners 5 are fastened as described above, force is applied in a direction in which an interval between the pushing plate 61 of the heat sink 6 and the bolster plate 4 becomes small. In a case where a bolster plate 40 of the related art, which has a structure with one sheet of a thick plate as illustrated in FIG. 7A, is used instead of the bolster plate 4, bending or deflection of a system board 20 easily occurs. The reasons will be described hereinafter. That is, when the fasteners 5, which are connected to a corner portion of a bolster plate 40 of the related art, are fastened, the bolster plate 40 is bent as illustrated in FIG. 7B. Here, the bending deformation of the bolster plate 40 is not uniform in a plane direction of the plate, and the bending amount is maximum at a central portion of the plate. Due to the bending deformation, a gap exists between the central portion of the bolster plate 40 and the system board 20 such that a lower surface (*e.g.,* the back surface) of the system board 20 may not be pressed. As a result, pressing force for pressing the lower surface of the system board 20 becomes smaller at the central portion side in comparison with an end side of the bolster plate 40.

For the reason described above, the pressing force for pressing the system board 20 easily becomes non-uniform in the bolster plate 40 of the related art, and due to the problems, bending or deflection of the system board 20 may easily occur. As a result, there is a concern in that a large amount of stress is applied to solder bumps of the semiconductor package in accordance with a location, and thus an electrode portion is damaged.

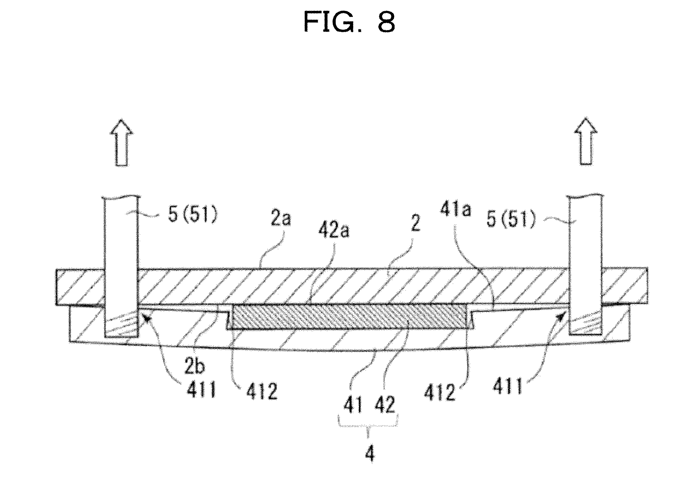

In this regard, the bolster plate 4 according to the present embodiment includes a separate plate structure in which the pressing plate portion 42 for pressing the lower surface (back surface) 2b of the system board 2 is provided separately from the base plate portion 41 in which the connection portion 411 connected to the fastener 5 is installed. Accordingly, even though the base plate portion 41 including the connection portion 411 is bent when the fasteners 5 are fastened, external force generated due to the fastening of the fasteners 5 is hardly applied to the pressing plate portion 42 that is installed as a separate member from the base plate portion 41 (see, for example, FIG. 8). Therefore, deformation such as bending or deflection of the pressing plate portion 42 is suppressed so as to maintain exactly uniform flatness of the pressing plate portion 42. As a result, the lower surface (back surface) 2b of the system board 2 may be uniformly pressed in the plane direction thereof by the pressing plate portion 42. Therefore, bending or deflection of the system board 2 may be properly suppressed. Accordingly, an excessive amount of stress is prevented from being applied to the solder bumps 35 of the semiconductor package 3, thereby properly suppressing the damage to the solder bumps 35.

As described above, the fixing structure 10 according to the present embodiment may uniformly press and fix the plurality of objects to be fixed. In addition, according to the fixing structure 10, the thermal sheet 7 interposed between the semiconductor package 3 mounted on the system board 2 and the heat sink 6 may be equally pressed. As a result, the degree of adhesion of the entire thermal sheet 7 to the pushing plate 61 and the heat spreader 34 may be increased, and therefore the cooling efficiency of the semiconductor chip 32 of the semiconductor package 3 may be improved.

Because the base plate portion 41 of the bolster plate 4 does not serve to press the system board 2, the base plate portion 41 may have low flatness in comparison with the pressing plate portion 42, thereby decreasing manufacturing costs. Meanwhile, the pressing plate portion 42 for pressing the system board 2 requires high flatness, and a plate thickness of the pressing plate portion 42 may be smaller than that of the bolster plate 40 of the related art that adopts a structure with one sheet of a thick plate. A surface processing for a metal plate may easily secure flatness at a metal plate of which the plate thickness is small in comparison with a metal plate of which the plate thickness is large. Therefore, since the pressing plate portion 42 of the present embodiment may be thinner than the bolster plate 40 having a structure of the related art, surface processing performance may be excellent, flatness may be easily secured, and manufacturing costs may be decreased.

According to the bolster plate 4 according to the present embodiment, the base plate portion 41 and the pressing plate portion 42 are separable from each other regardless of a bending amount of the base plate portion 41, thereby suppressing deformation in the pressing plate portion 42. Therefore, for example, a separate design is not required, in which a bending deformation amount of the bolster plate under a load is obtained in advance, and a shim for compensating for the bending deformation is disposed on the bolster plate. That is, there are advantages in that the bolster plate 4 according to the present embodiment and the fixing structure 10 including the bolster plate 4 have excellent versatility, and may be adopted to various electronic component units regardless of product specifications.

In the bolster plate 4 of the present embodiment, a planar size of the concave portion 412 is slightly larger than that of the pressing plate portion 42 such that a predetermined clearance is formed between the lateral surface of the pressing plate portion 42 and the lateral surface of the concave portion 412 when the pressing plate portion 42 is fitted into the concave portion 412. Accordingly, even though the base plate portion 41 is severely deformed in an outward direction from a surface when the fasteners 5 are fastened, a state where the pressing plate portion 42 is restrained by the base plate portion 41 may be suppressed. As a result, a large amount of external force is suppressed from being transmitted from the base plate portion 41 to the pressing plate portion 42, thereby suppressing deformation in the pressing plate portion 42.

In the bolster plate 4, a thickness dimension of the pressing plate portion 42 is larger than a depth dimension of the concave portion 412. For this reason, when the base plate portion 41 is bent due to the fastening of the fasteners 5, the upper surface (hereinafter, also referred to as "pressing surface") 42a of the pressing plate portion 42 may be suppressed from being inserted into the concave portion 412. Accordingly, the pressing surface 42a of the pressing plate portion 42 is prevented from being lower than the periphery of the concave portion 412 of the base plate portion 41, thereby uniformly pressing the lower surface 2b of the system board using the pressing surface 42a. As a result, bending or deflection of the system board is more difficult to occur.

In addition, in the present embodiment, the plate thickness and stiffness of the base plate portion 41 of the bolster plate 4 are large at the corner portion side in comparison with the central side at which the concave portion 412 is formed. In the base plate portion 41, stiffness of the corner portion at which the connection portion 411 is formed is relatively larger than that of the central portion, thereby suppressing damage to the connection portion 411. Meanwhile, even though the central portion of the base plate portion 41 is severely deformed, a large amount of external force is suppressed from being applied to the pressing plate portion 42 for pressing the system board 2, which does not cause problems. As described above, in the bolster plate 4 according to the present embodiment, there is an advantage in that a bending portion of the base plate portion 41 may be controlled by the fastening of the fasteners 5.

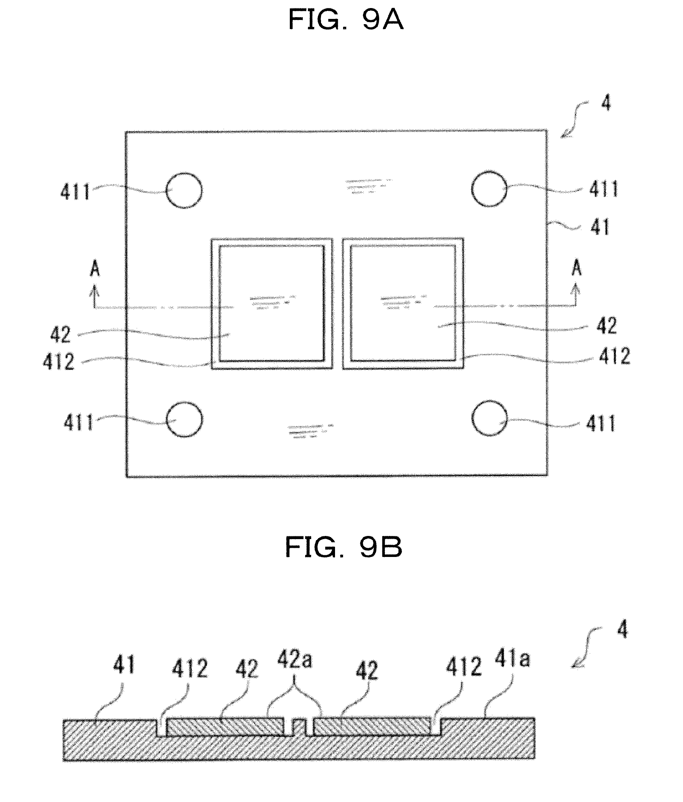

Meanwhile, the bolster plate 4 described above may be variously changed. For example, the number of pressing plate portions 42, which are laminated so as to be separable from the base plate portion 41, is not limited to a particular number. That is, a plurality of pressing plate portions 42 may be separably disposed on the base plate portion 41 of the bolster plate 4. In this case, as illustrated in FIGS. 9A and 9B, the plurality of pressing plate portions 42 may be disposed side by side in the plane direction of the base plate portion 41. FIG. 9A is a plan view according to a modified example of the bolster plate 4. FIG. 9B is a cross-sectional view taken along an arrow line A-A of FIG. 9A. In addition, three or more pressing plate portions 42 may be disposed on the base plate portion 41.

While an exemplary embodiment has been described in which the thickness dimension of the pressing plate portion 42 is larger than the depth dimension of the concave portion 412 of the base plate portion 41 has been described, both of the dimensions may be approximately the same as illustrated in FIG. 9B. That is, as long as the pressing surface 42a of the pressing plate portion 42 is not lower than the periphery of the concave portion 412 when the base plate portion 41 is bent due to the fastening of the fasteners 5, the relationship between the thickness of the pressing plate portion 42 and the depth of the concave portion 412 may be freely defined. Accordingly, even though the base plate portion 41 is bent due to the fastening of the fasteners 5, the lower surface 2b of the system board may be uniformly pressed by the pressing surface 42a of the pressing plate portion 42. In addition, as another modified example of the bolster plate 4, another pressing plate portion 42 may be laminated on one pressing plate portion 42. That is, a plurality of pressing plate portions 42 may be overlapped and laminated on the base plate portion 41.

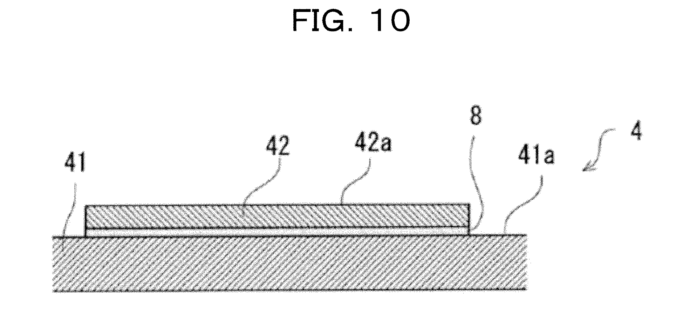

In the bolster plate 4, an aspect of attaching the pressing plate portion 42 to the base plate portion 41 is not limited to the aforementioned aspect as long as the pressing plate portion 42 and the base plate portion 41 are separable from each other. That is, the concave portion 412 for fitting the pressing plate portion 42 into the base plate portion 41 may not be formed. For example, as in a modified example illustrated in FIG. 10, the pressing plate portion 42 may be temporarily fixed (temporarily adhered) on the base plate portion 41 by a temporary fixing material 8. As the temporary fixing material 8, for example, a double-sided adhesive tape may be properly used. However, the temporary fixing material 8 is not limited to the double-sided adhesive tape, and various materials may be used instead of the double-sided adhesive tape. In addition, as a structure of the connection portion, which connects the fastener 5 (bolt 51) to the bolster plate 4 and the pushing plate 61, various structures may be adopted.

### <Embodiment 2>

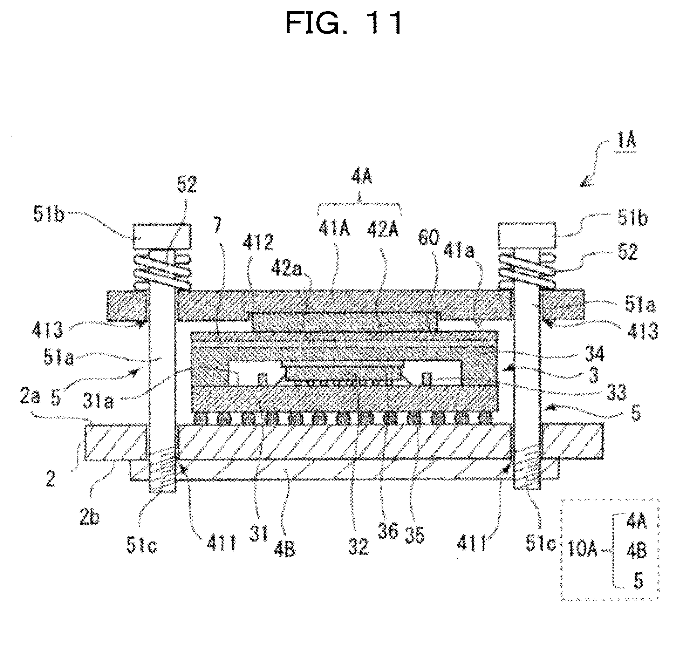

An electronic component unit 1A according to Embodiment 2 will be described next. FIG. 11 is a view schematically illustrating a cross-sectional structure of the electronic component unit 1A according to Embodiment 2. In Embodiment 2, an example will be described in which a member corresponding to the bolster plate 4 according to Embodiment 1 is disposed at an upper portion side of a semiconductor package 3.

In FIG. 11, a heat radiating plate 60 instead of the heat sink 6 of Embodiment 1 is installed on an upper portion of a semiconductor package 3 mounted on a system board 2. The heat radiating plate 60 is formed to be thinner than a pushing plate 61 of a heat sink 6. Further, a first reinforcing plate 4A is installed on an upper portion of the heat radiating plate 60 so as to be accommodated on the heat radiating plate 60. In addition, a second reinforcing plate 4B is disposed at a lower surface (back surface) 2b side of the system board 2. Hereinafter, the members in common with Embodiment 1 are indicated by the same reference numerals, a detailed description thereof is omitted, and a description will be made on the basis of a difference from Embodiment 1.

A thermal sheet 7 is interposed between a heat spreader 34 and the heat radiating plate 60 in the semiconductor package 3. Further, the first reinforcing plate 4A and the second reinforcing plate 4B are connected by fasteners 5, and as the fasteners 5 are fastened, force is applied in a direction in which an interval between the first reinforcing plate 4A and the second reinforcing plate 4B becomes small. Accordingly, the heat radiating plate 60 and the semiconductor package 3 are pressed against the system board 2, and then fixed to each other.

The second reinforcing plate 4B is a flat plate member that is disposed along the lower surface (back surface) 2b of the system board 2, and connection portions 411 are formed at four corners of the second reinforcing plate 4B. The connection portion 411 is similar to the connection portion 411 of the bolster plate 4 according to Embodiment 1, and a threaded portion 51c of a bolt 51 is screw-attached to the connection portion 411 so that the connection portion 411 is connected to one end of the bolt 51.

Meanwhile, similarly to the bolster plate 4 of Embodiment 1, the first reinforcing plate 4A includes a structure with a plurality of separate plates at a central side thereof. The first reinforcing plate 4A includes a base plate portion 41A, and a pressing plate portion 42A. The base plate portion 41A and the pressing plate portion 42A correspond to the base plate portion 41 and the pressing plate portion 42 of the bolster plate 4 of Embodiment 1, and include substantially the same structure. That is, as connection portions to which the fasteners 5 are connected, through holes 413 are formed at the four corners of the base plate portion 41A. Similarly to the through hole 61a, which is penetratively formed in the aforementioned pushing plate 61, the through hole 413 of the base plate portion 41A has a diameter larger than that of a shaft portion 51a of the bolt 51.

To connect the first reinforcing plate 4A and the second reinforcing plate 4B, the four bolts 51 are inserted into the through holes 413 of the base plate portion 41A, penetratively inserted into the through holes of the system board 2, and then screw-attached to the connection portions 411 provided at the corner portions of the second reinforcing plate 4B. In addition, a spring 52 is interposed between a head portion 51a of the bolt 51 and an upper surface of the base plate portion 41A of the first reinforcing plate 4A. In this way, the bolt 51 of the fastener 5 is fastened such that the first reinforcing plate 4A and the second reinforcing plate 4B are connected to each other by the bolt 51. Further, the heat radiating plate 60 is pressed by the first reinforcing plate 4A toward the semiconductor package 3, and the system board 2 is pressed by the second reinforcing plate 4B toward the semiconductor package 3.

The pressing plate portion 42A of the first reinforcing plate 4A is disposed at a planar central side of the base plate portion 41A, and is disposed to be laminated so as to be separable from the base plate portion 41A. Further, by fastening the fasteners 5, a pressing surface 42a of the pressing plate portion 42A presses an upper surface of the heat radiating plate 60. Referring to FIGS. 2 and 3, even in the base plate portion 41A of the present embodiment, a concave portion 412 is formed at the planar central side thereof. A surface of the base plate portion 41A, which is disposed so as to be opposite to the upper surface of the reinforcing plate 60, is defined as "an inner surface 41a". The concave portion 412 is formed in the inner surface 41a of the base plate portion 41A, and the pressing plate portion 42A is fitted into the concave portion 412.

The relationship between the concave portion 412 of the base plate portion 41A and the pressing plate portion 42A is similar to the relationship between the concave portion 412 of the base plate portion 41 and the pressing plate portion 42 according to Embodiment 1. That is, even in the first reinforcing plate 4A, a thickness of the pressing plate portion 42A is set to be larger than a depth of the concave portion 412. In addition, a planar size of the concave portion 412 is slightly larger than that of the pressing plate portion 42A so that a predetermined clearance is formed between a lateral surface of the pressing plate portion 42A and a lateral surface of the concave portion 412 when the pressing plate portion 42A is fitted into the concave portion 412. In this way, the pressing plate portion 42A fitted into the concave portion 412 of the base plate portion 41A is laminated on the base plate portion 41A in an aspect in which the pressing plate portion 42A is separable from the base plate portion 41A.

In the aforementioned electronic component unit 1A, a fixing structure 10A is implemented by including the first reinforcing plate 4A, the second reinforcing plate 4B, and the fasteners 5. Further, a plurality of objects to be fixed, that is, the heat radiating plate 60, the semiconductor package 3 and the system board 2, which are interposed between the first reinforcing plate 4A and the second reinforcing plate 4B, are pressed to each other, and then fixed to each other.

Further, similarly to the bolster plate 4 of Embodiment 1, in the present embodiment, the first reinforcing plate 4A adopts a combined structure of the base plate portion 41A and the pressing plate portion 42A so as to obtain the following advantages. That is, the first reinforcing plate 4A includes a separate plate structure in which the base plate portion 41A connected to the fasteners 5 and the pressing plate portion 42A for pressing the heat radiating plate 60 are separately provided from each other, such that even though the base plate portion 41A is bent, deformation in the pressing plate portion 42A due to the bending may be suppressed.

As a result, even after the fasteners 5 are fastened, high flatness of the pressing surface 42a of the pressing plate portion 42A may be maintained. Therefore, the pressing surface 42a of the pressing plate portion 42A may uniformly press the upper surface of the heat radiating plate 60 in a plane direction of the heat radiating plate 60. Therefore, bending or deflection of the heat radiating plate 60 may be properly suppressed. Accordingly, the thermal sheet 7 interposed between the heat radiating plate 60 and the heat spreader 34 may be uniformly compressed such that the efficiency of transferring the heat between the heat spreader 34 and the heat radiating plate 60 may be improved. Therefore, the heat may be efficiently radiated from the heat radiating plate 60 such that cooling efficiency of the semiconductor chip 32 may be improved.

In the present embodiment, deflection or bending deformation of the heat radiating plate 60 is suppressed by a function of the first reinforcing plate 4A such that the heat radiating plate 60 may be formed as a thin metal plate. Therefore, reduction in weight, reduction in installation space, reduction in manufacturing costs, and the like may be expected in comparison with the heat sink of the related art. In addition, the heat sink may be installed at a position closer to the semiconductor chip 32 of the semiconductor package 3 such that it is advantageous in terms of improving cooling efficiency.

### <Modified example>

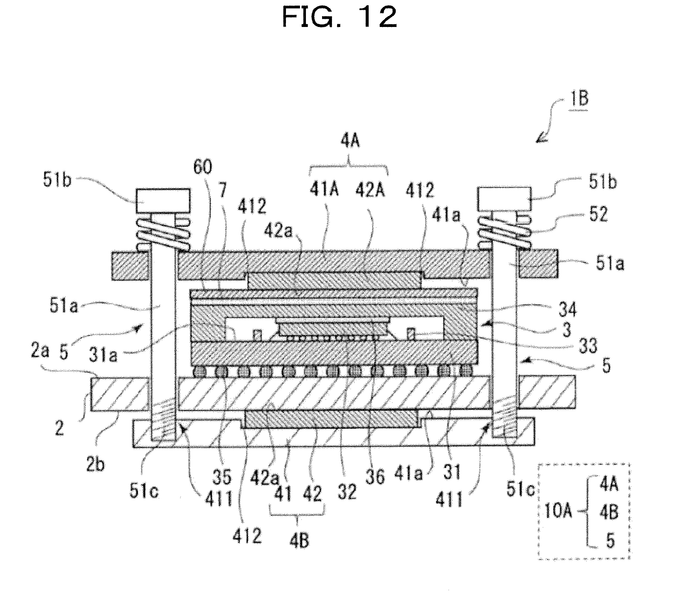

As in a modified example illustrated in FIG. 12, a second reinforcing plate 4B may include the same structure as the structure of the first reinforcing plate 4A and the bolster plate 4. In an electronic component unit 1B illustrated in FIG. 12, the second reinforcing plate 4B includes substantially the same structure as the bolster plate 4 according to Embodiment 1, and includes a base plate portion 41 and a pressing plate portion 42. As such, in addition to the first reinforcing plate 4A, the second reinforcing plate 4B also includes a separate plate structure in which a portion connected to a fastener 5 and a portion for pressing objects to be fixed are separately provided such that the plurality of objects to be fixed may be more precisely and uniformly pressed. Therefore, in a semiconductor package 3 of the electronic component unit 1B, a semiconductor chip 32 may be efficiently cooled, and at the same time, the damage to a solder bump 35 may be properly suppressed.

While the electronic component unit and the fixing structure according to the present disclosure have been described above by the embodiments, the present disclosure is not limited thereto. Further, it is obvious to the persons skilled in the art that various changes, modifications, combinations, and the like of the embodiments are possible. For example, while the aforementioned embodiments adopts an air cooling type heat sink, but for example, a liquid cooling type heat sink may also be adopted.

All examples and conditional language recited herein are intended for pedagogical purposes to aid the reader in understanding the disclosure and the concepts contributed by the inventor to furthering the art, and are to be construed as being without limitation to such specifically recited examples and conditions, nor does the organization of such examples in the specification relate to a showing of the superiority and inferiority of the disclosure. The scope of the invention is defined by the claims. Although the embodiments of the present disclosure have been described in detail, it should be understood that the various changes, substitutions, and alterations could be made hereto without departing from the scope of the invention.

## Claims

1. A fixing structure comprising:
one set of pushing plates disposed to be opposite to each other;
a plurality of fasteners that connects corner portions of the one set of pushing plates to each other;
wherein the fixing structure fixes a plurality of objects to be fixed by interposing a plurality of objects to be fixed between the one set of pushing plates and fastening the plurality of fasteners,
wherein at least one of the one set of pushing plates includes a base plate portion including a connection portion to which each of the plurality of fasteners is connected and a pressing plate portion which is disposed at a planar central side of the base plate portion, and separably laminated on the base plate portion to press the objects to be fixed.

2. The fixing structure according to claim 1, wherein the pressing plate portion is fitted into a concave portion formed in a surface of the base plate portion.

3. The fixing structure according to claim 2, wherein a gap is formed between a lateral surface of the pressing plate portion and a lateral surface of the concave portion.

4. The fixing structure according to claim 2 or claim 3, wherein a thickness dimension of the pressing plate portion is larger than a depth dimension of the concave portion.

5. An electronic component unit including the fixing structure according to claim 1, wherein
the plurality of objects include a substrate and a semiconductor package mounted on a front surface of the substrate,
one of the one set of pushing plates is a portion of a heat sink installed on the semiconductor package, and
the other of the one set of pushing plates is a reinforcing plate disposed on a back surface of the substrate,
wherein the semiconductor package is pressed and fixed on the substrate by fastening the plurality of fasteners, and the reinforcing plate includes a base plate portion including a connection portion to which each of the plurality of fasteners is connected, and a pressing plate portion which is disposed at a planar central side of the base plate portion, and separably laminated on the base plate portion to press the back surface of the substrate.

6. An electronic component unit including the fixing structure according to claim 1, wherein
the plurality of objects include a substrate, a semiconductor package mounted on a front surface of the substratea semiconductor package mounted on a front surface of a substrate, and a heat radiating plate disposed on the semiconductor package,
one of the one set of pushing plates is a first reinforcing plate installed on the heat radiating plate, and
the other of the one set of pushing plates is a second reinforcing plate disposed on a back surface of the substrate,
wherein the heat radiating plate and the semiconductor package are pressed and fixed on the substrate by fastening the plurality of fasteners, and the first reinforcing plate includes a base plate portion including a connection portion to which each of the plurality of fasteners is connected, and a pressing plate portion which is disposed at a planar central side of the base plate portion, and separably laminated on the base plate portion to press an upper surface of the heat radiating plate.

7. The electronic component unit according to claim 6, wherein the second reinforcing plate includes a base plate portion including a connection portion to which each of the plurality of fasteners is connected, and a pressing plate portion which is disposed at a planar central side of the base plate portion, and separably laminated on the base plate portion to press the back surface of the substrate.

8. The electronic component unit according to one of claims 5 to 7, wherein the pressing plate portion is fitted into a concave portion formed in a surface of the base plate portion.

9. The electronic component unit of claim 8, wherein a gap is formed between a lateral surface of the pressing plate portion and a lateral surface of the concave portion.

10. The electronic component unit of one of claims 8 and 9, wherein a thickness dimension of the pressing plate portion is larger than a depth dimension of the concave portion.

11. The electronic component unit of claim 9, wherein a thickness dimension of the pressing plate portion is larger than a depth dimension of the concave portion.
